# FASCICULE DE BREVET EUROPEEN

(11) **EP 3 629 073 B1**
(45) Date de publication et mention de la délivrance du brevet: **01.09.2021**
(21) Numéro de dépôt: 19190164.4
(22) Date de dépôt: 06.08.2019
(51) Int. Cl.: G02B 27/00, B60S 1/56, G03B 17/02, B60R 11/04

(54) **DISPOSITIF DE PROTECTION D'UN CAPTEUR OPTIQUE D'UN SYSTÈME D'ASSISTANCE À LA CONDUITE POUR VÉHICULE AUTOMOBILE**
SCHUTZVORRICHTUNG EINES OPTISCHEN SENSORS EINES LENKASSISTENZSYSTEMS FÜR KRAFTFAHRZEUG
DEVICE FOR PROTECTING AN OPTICAL SENSOR OF A DRIVING-ASSISTANCE SYSTEM FOR MOTOR VEHICLE

(30) Priorité: 27.09.2018 FR 1858843
(43) Date de publication de la demande: 01.04.2020
(73) Titulaire: Valeo Systèmes d'Essuyage, 78322 Le Mesnil Saint Denis (FR)
(72) Inventeur: BRETAGNOL, Frédéric, 63500 ISSOIRE (FR); TREBOUET, Marcel, 78322 Le Mesnil Saint Denis (FR)
(74) Mandataire: Valeo Visibility

(56) Documents cités:
- EP-A1- 3 045 969
- WO-A1-2016/045955
- WO-A1-2018/091641

## Description

La présente invention se rapporte au domaine de l'aide à la conduite et notamment aux systèmes d'assistance à la conduite, implantés sur certains véhicules, le système d'assistance à la conduite pouvant comporter un capteur optique, comme par exemple une caméra comprenant un objectif. Plus particulièrement, l'invention concerne un boîtier de protection d'un tel capteur optique.

Actuellement, des capteurs optiques et par exemple des caméras de vision avant, arrière, ou encore latérales, équipent un grand nombre de véhicules automobiles. Elles font notamment partie de systèmes d'assistance à la conduite, tels que des systèmes d'aide au stationnement, ou encore des systèmes de détection de franchissement de ligne. Afin de détecter au mieux les obstacles situés tout autour du véhicule, il est connu d'installer les capteurs optiques des systèmes d'assistance à la conduite sur le pourtour des véhicules en différents endroits selon l'utilisation souhaitée, par exemple intégrés dans les pare-chocs arrière ou avant, dans les bandeaux de renfort latéraux, ou au niveau de la plaque d'immatriculation arrière ou avant du véhicule.

Les documents WO 2018/091641 A1, WO 2016/045955 A1 et EP 3 045 969 A1 décrivent des capteurs connus.

Les capteurs optiques sont dans ce cas fortement exposés aux projections de saletés minérales ou organiques qui peuvent se déposer sur la surface optique correspondante et ainsi réduire l'efficacité de la prise de vue ou de la détection d'informations, voire rendre totalement inopérant le capteur, détecteur, ou caméra concerné(e). En particulier par temps de pluie, on constate des projections de pluie et de saletés qui peuvent grandement affecter l'opérabilité du système d'assistance à la conduite comprenant un tel capteur optique.

On comprend dès lors que les surfaces optiques des capteurs doivent être nettoyées afin de garantir leur bon état de fonctionnement, et ce besoin est d'autant plus important dans le cas d'un véhicule autonome, dans lequel le pilotage du véhicule est réalisé par l'intermédiaire des informations recueillies par les caméras.

Il est ainsi connu d'agencer un dispositif de nettoyage de l'optique du capteur à proximité de cette optique afin de supprimer les éléments polluants qui s'y sont déposés au préalable. Notamment, les dispositifs de nettoyage peuvent consister en des gicleurs alimentés en fluide de nettoyage. Le cas échéant, ces gicleurs peuvent être agencés en extrémité d'un dispositif télescopique configuré pour passer d'une position de repos escamotée à une position déployée de nettoyage. Si l'utilisation de ces gicleurs permet un nettoyage approprié des capteurs, elle génère des coûts de fonctionnement importants car il est nécessaire de prévoir des quantités de fluide de nettoyage assez importantes et des moyens de cinématique du gicleur sophistiqués.

De manière alternative, il est connu de prévoir des dispositifs de nettoyage comportant d'une part une vitre de protection, agencée en regard de la surface optique du capteur de manière à ce que les salissures se déposent sur cette vitre et non pas directement sur la surface optique, et d'autre part des moyens de vibration qui sont pilotés pour faire vibrer la vitre de protection afin d'en décoller les saletés. Toutefois, il a été constaté que l'efficacité d'un tel dispositif pour des salissures tenaces et incrustées peut être limitée malgré la vibration de la vitre de protection.

Une autre alternative prévoit qu'un capteur, et plus particulièrement une caméra, de système d'assistance à la conduite soit associé à un dispositif de protection qui comprend un boîtier de protection logeant la caméra en la protégeant de l'environnement extérieur. Le boîtier de protection comporte un élément optique, transparent et agencé en vis-à-vis de l'objectif de la caméra pour permettre des prises de vue. Le boîtier de protection et l'élément optique associé sont entraînés en rotation par l'intermédiaire d'un moteur formant partie du dispositif de protection. Plus particulièrement, le moteur est configuré pour entrainer la rotation du boîtier de protection à une vitesse suffisante pour retirer par effet centrifuge des salissures ou de l'eau pouvant être présent sur l'élément optique. Cette solution de nettoyage par effet centrifuge est nettement plus efficace que la mise en vibration de l'élément optique décrite ci-dessus.

Un tel système de nettoyage fonctionnant par effet centrifuge, c'est-à-dire comportant un boîtier rotatif autour de la caméra, implique des difficultés à rendre étanche la cavité dans laquelle s'étend la caméra, aussi bien par rapport à l'air qu'à l'humidité. Par ailleurs, le fonctionnement de la caméra à l'intérieur du boîtier rotatif entraîne une augmentation de la température et donc une modification de la pression dans la cavité logeant cette caméra, amplifiant alors la circulation d'air, et l'entrée d'humidité, à l'intérieur du boîtier de protection. Il peut en résulter l'apparition de condensation interne aussi bien sur la lentille que sur la face interne de l'élément optique solidaire en rotation du boîtier de protection, ce qui peut perturber l'acquisition de données par le capteur et par exemple la caméra.

Afin de limiter un phénomène de condensation au niveau de l'élément optique, il est connu de réaliser des orifices à travers une paroi du boîtier. Chaque orifice permet une communication et le passage d'un flux d'air entre l'intérieur et l'extérieur du boîtier. Afin de prévenir de l'introduction d'humidité dans le boîtier de protection, chaque orifice est recouvert par une membrane semi-perméable, c'est-à-dire perméable à l'air, mais imperméable à l'eau. Cette solution permet ainsi une bonne ventilation entre la caméra et l'élément optique, afin d'empêcher l'accumulation de condensation sur l'élément optique. Toutefois, cette solution présente l'inconvénient de devoir percer le boîtier et donc de modifier l'équilibre de sa masse. Un autre inconvénient consiste en ce que les membranes soumises à la force centrifuge ont tendance à se détériorer, à se déformer ou pire à se décoller du boîtier, amplifiant ce phénomène de déséquilibre. Le centre de gravité du boîtier se trouve alors décalé par rapport à l'axe de rotation du moteur. Ce décalage provoque des contraintes asymétriques sur l'arbre du moteur lors de sa mise en rotation, générant des sifflements ou pire une déformation irréversible de son arbre.

La présente invention se propose de résoudre ce problème technique, en présentant une alternative aux dispositifs de protection d'un capteur optique connus, permettant d'empêcher ou à tout le moins de limiter un phénomène de condensation à l'intérieur du dispositif de protection tout en préservant son équilibre lors de sa mise en rotation.

À cet effet l'invention a pour objet un dispositif de protection d'un capteur optique de système d'assistance à la conduite pour véhicule automobile, le dispositif de protection comportant d'une part un boîtier de protection formant une cavité apte à recevoir au moins en partie le capteur optique comprenant une surface optique, le boîtier de protection comprenant un élément optique configuré pour être disposé en regard de la surface optique du capteur optique, le boîtier de protection étant configuré pour être mobile en rotation autour d'un axe, et comportant d'autre part un moteur configuré pour entraîner en rotation le boîtier de protection à des vitesses permettant le nettoyage de l'élément optique par effet centrifuge, le dispositif de protection étant configuré de manière à présenter une partie mobile et une partie fixe.

L'invention est remarquable en ce que le dispositif de protection comporte un système d'équilibrage de pression comportant un orifice de mise à l'air libre permettant la communication fluidique entre l'intérieur et l'extérieur du dispositif de protection, l'orifice de mise à l'air libre étant réalisé dans la partie fixe du dispositif de protection.

L'orifice de mise à l'air libre permet un renouvellement de l'air présent dans le boîtier et notamment une évacuation de l'air de manière à éviter une formation de condensation au niveau de l'optique du capteur optique et/ou de l'élément optique du boîtier. Et, de façon avantageuse, l'invention propose de renouveler l'air présent dans le boîtier en localisant l'orifice de mise à l'air dans une partie fixe distincte du boîtier, de telle sorte que l'on ne pratique pas d'ouverture dans le boîtier rotatif. De ce fait, l'équilibre de la masse du boîtier est préservé et aucune contrainte n'est exercée sur l'actionneur lorsque ce dernier met en rotation le boîtier. Selon un autre avantage, l'invention permet également d'éviter un phénomène d'accumulation de condensation à l'intérieur du premier sous-ensemble.

Selon un aspect, le dispositif de protection est un élément distinct de l'élément optique.

Selon une alternative, le dispositif de protection fait partie de l'élément optique.

Selon différentes caractéristiques de l'invention, prises seules ou en combinaison, on pourra prévoir que :
- le système d'équilibrage de pression comporte des moyens de circulation d'un flux d'air entre d'une part la cavité formée par le boîtier de protection formant partie de la partie mobile du dispositif de protection et d'autre part l'orifice de mise à l'air libre réalisé dans la partie fixe du dispositif de protection.
- le capteur optique est porté par un élément support dont au moins une embase est disposée dans la cavité, les moyens de circulation d'un flux d'air comportant au moins un orifice de passage d'air réalisé dans l'épaisseur de l'embase de l'élément support.
- l'élément support comporte un corps tubulaire prolongeant l'embase, ledit corps tubulaire étant creux pour former un conduit de circulation d'air formant communication fluidique entre l'orifice de passage d'air et l'orifice de mise à l'air libre. Le conduit est ainsi tel qu'il s'étend entre une première extrémité débouchant à l'intérieur du boîtier, et une seconde extrémité débouchant sur un dégagement dans lequel sont ménagés un ou plusieurs orifices de mise à l'air libre.
- le corps tubulaire est configuré pour servir de guide à un faisceau de câbles de connexion électrique et vidéo, le faisceau et le corps tubulaire étant dimensionnés pour laisser un passage de communication fluidique entre l'orifice de passage d'air et l'orifice de mise à l'air libre.
- un embout est rendu solidaire d'un carter du moteur, à l'opposé du boîtier de protection, ledit orifice de mise à l'air libre étant réalisé dans une paroi périphérique de l'embout.
- le dispositif de protection comprend un organe de déflexion de liquide positionnée à l'extérieur du dispositif de protection et en vis-à-vis de l'orifice de mise à l'air libre.
- l'orifice de mise à l'air libre est équipé d'une membrane semi-perméable.
- le dispositif de protection comporte des moyens d'absorption de l'humidité.

L'invention concerne également un véhicule automobile comprenant un dispositif de protection d'un capteur optique d'un système d'assistance à la conduite, tel que décrit ci-dessus, caractérisé en ce que l'orifice de mise à l'air libre réalisé dans la partie fixe est orienté vers le sol ou sensiblement vers le sol lorsque le véhicule automobile est en situation de conduite.

D'autres caractéristiques et avantages de l'invention apparaitront plus clairement à la lecture de la description suivante, donnée à titre d'exemple illustratif et non limitatif, et des dessins annexés parmi lesquels :
- la figure 1 représente une vue de face d'un véhicule automobile, comprenant au niveau de sa calandre, un système d'assistance à la conduite ;
- la figure 2 représente de façon schématique et en perspective une vue d'un dispositif de protection d'un capteur optique d'un système d'assistance à la conduite ;
- la figure 3 représente de façon schématique une coupe longitudinale du dispositif de protection de la figure 2, rendant notamment visible un système d'équilibrage de pression permettant d'éviter ou limiter la formation d'humidité à l'intérieur du dispositif de protection.

Il faut tout d'abord noter que les figures exposent l'invention de manière détaillée pour mettre en œuvre l'invention, lesdites figures pouvant bien entendu servir à mieux définir l'invention le cas échéant. Sur ces figures, les éléments identiques portent les mêmes références. Les différentes réalisations sont des exemples. Bien que la description se réfère à un ou plusieurs modes de réalisation, ceci ne signifie pas nécessairement que chaque référence concerne le même mode de réalisation, ou que les caractéristiques s'appliquent à un seul mode de réalisation. De simples caractéristiques de différents modes de réalisation peuvent également être combinées ou interchangées pour fournir d'autres réalisations.

Par ailleurs, il convient de noter que dans la description, on peut indexer certains éléments, avec par exemple un premier élément ou un deuxième élément. Dans ce cas, il s'agit d'un simple indexage pour différencier et dénommer des éléments proches, mais non identiques. Cette indexation n'implique pas une priorité d'un élément par rapport à un autre et on peut aisément interchanger de telles dénominations sans sortir du cadre de la présente description.

Un véhicule 100 est équipé selon l'invention d'un système d'assistance à la conduite 1, qui comporte au moins un capteur optique 2 et un dispositif de protection 4 agencé autour de ce capteur optique. Dans l'exemple illustré, il a été plus particulièrement rendu visible un capteur optique 2 formé par une caméra de vision avant disposée dans la calandre 5 du véhicule, mais on comprendra que ce qui va suivre en relation avec un tel capteur optique pourra être mis en œuvre pour des dispositifs disposés également ou alternativement à l'arrière ou latéralement par rapport au véhicule. Selon l'invention, au moins le dispositif de protection 4 associé au capteur optique 2 est configuré pour empêcher ou limiter l'apparition de condensation sur les surfaces optiques du dispositif de protection et/ou du capteur optique.

Le capteur optique 2 est par exemple un capteur optique de prise de vues tel qu'une caméra. Il peut s'agir d'un capteur CCD (pour "charged coupled device" en anglais à savoir un dispositif à transfert de charge) ou d'un capteur CMOS comportant une matrice de photodiodes miniatures. Selon une autre variante, sans que pour autant cette liste soit exhaustive, il peut s'agir d'un capteur pour télédétection par laser dit capteur LIDAR, acronyme en anglais de "light détection and ranging".

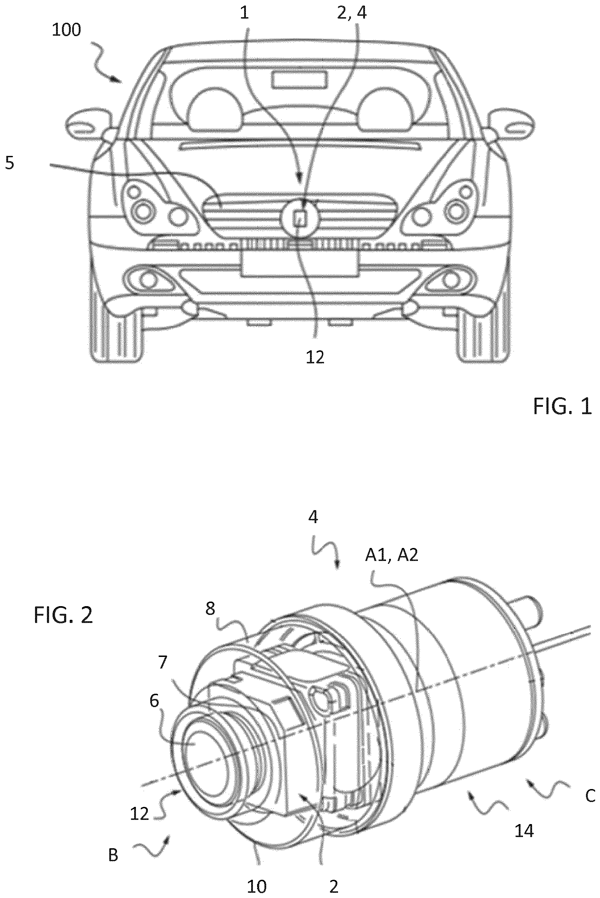

Sur la figure 2, le dispositif de protection 4 a été représenté partiellement transparent pour rendre visible le capteur optique 2 logé dans le dispositif de protection 4. Le capteur optique 2 comporte une surface optique 6 et un axe optique 7. La surface optique 6 est par exemple un objectif de caméra, qui peut comporter une ou plusieurs lentilles suivant le champ de vision et la résolution souhaités.

Le capteur optique 2 est monté au moins en partie dans un boîtier de protection 8 formant un premier sous-ensemble B du dispositif de protection 4. Pour ce faire, le boîtier de protection 8 comporte une paroi 10 délimitant une cavité 11 dans laquelle est logé le capteur optique. Cette paroi 10 est de préférence centrée autour de l'axe optique 7 du capteur optique 2. Dans l'exemple illustré, la paroi 10 est de forme sensiblement cylindrique.

Le boîtier de protection 8 comprend également un élément optique 12 formé par une paroi transparente et disposé en aval de la surface optique 6 du capteur optique 2. Cet élément optique 12 est avantageusement dimensionné de façon à recouvrir toute la surface optique 6. En d'autres termes, l'élément optique 12 est agencé dans le champ de vision du capteur optique 2, la paroi transparente permettant de ne pas nuire à l'efficacité du capteur optique 2. L'élément optique 12 peut être réalisé d'une seule pièce avec le boîtier de protection 8. En alternative, le boîtier de protection 8 et l'élément optique 12 peuvent être deux pièces distinctes solidarisées entre elles. La paroi transparente formant tout ou partie de l'élément optique 12 peut être réalisée en verre ou en un matériau plastique tel que du polycarbonate. Le boîtier de protection 8 peut être réalisé en tout matériau approprié connu de l'homme du métier, de préférence à partir d'un matériau étanche.

Par disposition de l'élément optique 12 en aval de la surface optique 6, on comprend que l'élément optique 12 est disposé entre l'extérieur du véhicule et la surface optique 6 du capteur optique 2, de sorte que l'élément optique 12 protège la surface optique 6 des projections éventuelles de salissures ou débris solides qui pourraient abimer cette surface optique 6. Il s'agit donc d'un élément de protection, ou plus précisément d'un masque de protection du capteur optique 2, et c'est cet élément optique 12 qui est soumis aux agressions provenant de l'extérieur, c'est-à-dire aussi bien des projections d'eau, de polluants, de graviers que des dépôts de polluants ou des traces d'eau. Afin de permettre le nettoyage de la surface de l'élément optique 12 par effet centrifuge, comme décrit ci-dessus, le dispositif de protection 4 comporte un moteur 14 formant un deuxième sous-ensemble C. Le moteur 14 est couplé au boîtier de protection 8 de façon à entrainer en rotation le boîtier de protection 8 et donc l'élément optique 12 autour d'un axe de rotation A1, confondu avec l'axe optique 7 du capteur optique 2.

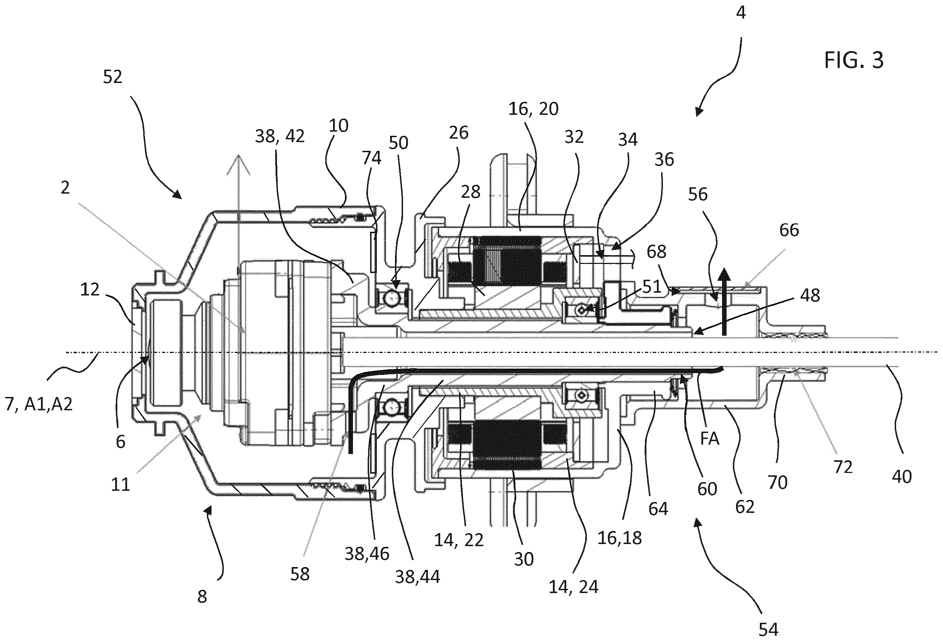

La vue en coupe de la figure 3 rend plus particulièrement visible la structure du dispositif de protection et les moyens mis en œuvre pour empêcher ou limiter la condensation susceptible de se former sur la surface optique de la caméra ou sur la face interne de l'élément optique.

Le moteur 14 formant le deuxième sous-ensemble C est monté rotatif autour d'un axe de rotation A2 confondu avec l'axe de rotation A1 du premier sous-ensemble B, et avec l'axe optique 7 du capteur optique 2.

Le moteur 14 comporte un carter 16 dont une paroi de fond 18 et une paroi périphérique 20 forment un logement à l'intérieur duquel sont disposés un rotor 22 et un stator 24. Le stator 24 est ici fixé sur une face interne de la paroi périphérique 20 de ce carter 16, le rotor 22 étant mobile en rotation par rapport au stator 24 fixe.

Dans le mode de réalisation illustré, le moteur est un moteur à rotor interne, le rotor 22 tournant à l'intérieur du stator 24. On comprendra que l'on pourra envisager que, sans sortir du contexte de l'invention, le moteur comporte un rotor externe.

Le boîtier de protection 8 et l'élément optique 12 associé sont solidaires du rotor 22 du moteur 14. Dans l'exemple illustré, une pièce de liaison intermédiaire 26 est disposée entre le rotor 22 et le boîtier de protection 8, en étant solidaire à chacune de ses extrémités longitudinales de l'un et de l'autre de ces composants. L'entraînement en rotation du rotor 22 par l'intermédiaire de l'alimentation électrique du stator 24 permet la mise en rotation de la pièce de liaison intermédiaire qui entraîne en rotation le boîtier de protection 8 et l'élément optique 12 à nettoyer par force centrifuge le cas échéant.

Le moteur 14 comprend au moins un aimant 28 solidaire du rotor 22, et un nombre prédéfini de bobines électromagnétiques 30 montées sur le stator 24 et alimentées en courant pour générer un champ magnétique dans lequel est susceptible de se déplacer cet au moins un aimant 28. Le moteur 14 comprend à cet effet un circuit de commande 32 pour l'alimentation des bobines électromagnétiques 30. Ce circuit de commande 32 est relié à un faisceau d'alimentation électrique 34 représenté schématiquement sur la figure 3 et par exemple relié au circuit électrique général du véhicule 100, en passant à travers un orifice de sortie 36 ménagé dans la paroi de fond 18 du carter 16 du moteur 14, tel que cela est visible sur la figure 3.

Dans le mode de réalisation illustré, le rotor 22 est disposé autour d'un élément support 38 solidaire du capteur optique 2 et formant gaine pour un faisceau de câbles de connexion électrique et vidéo 40.

L'élément support 38 comporte une embase 42 solidaire de la partie arrière de la caméra et un corps tubulaire 44 disposé dans le prolongement longitudinal de l'embase 42 et à l'intérieur duquel circule le faisceau de câbles de connexion électrique et vidéo 40.

On comprend que la partie arrière de la caméra correspond à la partie tournée à l'opposé de l'optique de la caméra, vers l'intérieur du boîtier de protection 8.

Dans l'exemple illustré, l'élément support 38 comporte un palier intermédiaire 46 dont le diamètre permet une continuité entre l'embase 42, de diamètre sensiblement égal à une dimension correspondante de la caméra, et le corps tubulaire 44, de diamètre légèrement supérieur à celui du faisceau de câbles de connexion électrique et vidéo 40.

Le corps tubulaire 44 comporte une extrémité libre 48, c'est-à-dire l'extrémité à l'opposé de l'embase 42, ouverte de sorte que le faisceau de câbles de connexion électrique et vidéo 40 s'étend au-delà de cette extrémité libre du corps tubulaire 44.

Le rotor 22 est disposé autour de la face externe du corps tubulaire 44 de l'élément support, de sorte que l'élément support sert de moyen de guidage en rotation du rotor.

Le dispositif de protection 4, et plus particulièrement au niveau du deuxième sous-ensemble C, comprend deux roulements 50, 51 pour assurer un pivotement approprié d'une partie mobile 52 du dispositif de protection, formé notamment par le rotor 22 du moteur, le boitier de protection 8 et l'élément optique 12, par rapport à une partie fixe 54 du dispositif de protection 4, formé notamment par le stator 24 du moteur 14.

Plus particulièrement, en se référant à l'exemple illustré sur la figure 3, les deux roulements sont disposés l'un entre l'élément support 38 solidaire du capteur optique et la pièce intermédiaire 26 et l'autre entre ce même élément support 38 solidaire du capteur optique et le rotor 22. On comprend que cet agencement n'est qu'un exemple non limitatif et que le nombre et la position des roulements pourraient varier dès lors que cela permet la rotation de la partie mobile 52 par rapport à la partie fixe 54 du dispositif de protection.

Selon l'invention, le dispositif de protection 4 comporte un système d'équilibrage de pression configuré pour empêcher ou à tout le moins limiter la condensation sur la paroi transparente formant l'élément optique 12 solidaire de ce boîtier de protection 8, et le système d'équilibrage de pression est spécifique en ce qu'il comporte un orifice de mise à l'air libre 56, permettant une communication fluidique entre l'extérieur et l'intérieur du dispositif de protection, qui est réalisé dans la partie fixe 54 du dispositif de protection 4. Tel que cela va être décrit ci-après, le système d'équilibrage de pression peut comporter par ailleurs des moyens de communication fluidique permettant de guider un flux d'air entre cet orifice de mise à l'air libre et la cavité 11 formée par le boîtier de protection 8 et à l'intérieur de laquelle est logée le capteur optique.

Le système d'équilibrage de pression comporte en outre ici un orifice de passage d'air 58 et un conduit de circulation 60. L'orifice de passage d'air est réalisé dans l'embase 42 de l'élément support 38, pour permettre à un flux d'air FA, illustré par une flèche sur la figure 3, de circuler depuis la cavité 11 dans laquelle s'étend l'embase 42 de l'élément support 38 jusqu'à l'orifice de mise à l'air libre 56 réalisé dans une paroi fixe, par l'intermédiaire notamment du conduit de circulation 60 ménagé le long du corps tubulaire 44 de l'élément support et à l'intérieur de celui-ci, le flux d'air passant à travers l'extrémité libre 48 ouverte du corps tubulaire 44 de l'élément support. De la sorte, la rotation du boîtier de protection et l'élévation de température qui en résulte est compensée par une évacuation de l'air chaud, via le trajet de flux d'air FA, vers l'extérieur du dispositif de protection, de manière à éviter ou limiter l'apparition de condensation sur les surfaces optiques tournées vers l'intérieur de la cavité 11 formée par le boîtier de protection 8.

A titre d'exemple non limitatif, l'orifice de passage d'air 58 réalisé de manière traversante dans l'épaisseur de l'élément support 38 présente une section de passage comprise entre 1.5 mm et 4 mm, et l'orifice de mise à l'air libre 56 présente une section de passage comprise entre 1.5 mm et 4 mm. Les sections de passage de l'orifice de passage d'air 58 et de l'orifice de mise à l'air libre 56 sont proportionnelles au volume de la caméra.

Les sections de passage de l'orifice de passage d'air 58 et de l'orifice de mise à l'air libre 56 peuvent être carrées, rectangulaires ou encore circulaires.

De manière préférée, la section de passage de l'orifice de mise à l'air libre 56 est de dimension sensiblement égale à celle de l'orifice de passage d'air 58.

Il convient de noter qu'à la fois l'orifice de passage d'air 58 et l'orifice de mise à l'air libre 56 sont réalisés dans des éléments structurels fixes, à savoir respectivement dans l'élément support 38 fixe et dans une partie fixe solidaire du stator 24, de sorte qu'aucun balourd n'est créé lors de la rotation du boîtier de protection.

L'orifice de mise à l'air libre 56 peut être formé dans le carter 16 du moteur 14 dès lors que le conduit de circulation 60 ici réalisé le long du corps tubulaire 44 de l'élément support 38 permet le passage de l'air jusqu'à cet orifice de mise à l'air libre 56.

Dans l'exemple illustré sur la figure 3, l'orifice de mise à l'air libre 56 est réalisé dans un embout 62 disposé contre la face externe de la paroi de fond 18 du carter du moteur et formant moyen d'étanchéité autour de l'élément support 38 dépassant en saillie de cette paroi de fond 18.

Plus particulièrement, l'embout 62 peut être disposé autour d'un manchon 64 formant saillie de la paroi de fond 18 et formant de la sorte un guide pour l'élément support 38 de la caméra.

L'orifice de mise à l'air libre 56 est équipé d'une membrane semi-perméable 66, c'est-à-dire une membrane à la fois perméable à l'air et imperméable aux liquides et notamment à l'eau. Notamment, la membrane peut être hydrophobe et le cas échéant oléophobe, en présentant un revêtement microporeux.

La membrane semi-perméable 66 est associée à l'orifice de mise à l'air libre 56 de manière étanche, par collage ou encore par soudure par ultrasons. Tel qu'illustré sur la figure 3, la membrane 66 peut notamment à cet effet être disposée dans un lamage 68 agencé dans le prolongement de l'orifice de mise à l'air libre et de dimensions supérieures à cet orifice, afin de permettre le soudage ou collage en périphérie de la membrane 66.

L'embout 62 est maintenu hermétiquement, par des moyens connus, contre la paroi de fond 18 du carter 16 du moteur 14. L'embout 62 présente une forme cylindrique creuse formant un dégagement dans lequel débouche l'extrémité libre 48 du corps tubulaire de l'élément support 38. L'orifice de mise à l'air libre 56 est formé dans une paroi périphérique de l'embout 62 et une gaine 70 est disposée dans le prolongement axial du manchon 64 en saillie de la paroi de l'embout disposée à l'opposé de ce manchon, la gaine 70 permettant au faisceau de câbles électrique et vidéo de traverser de part en part l'embout 62 pour être relié aux moyens de commande appropriés. De façon avantageuse, la gaine 70 est équipée d'un élément d'étanchéité 72, réalisé dans un matériau élastique ou sensiblement élastique de manière à entourer de façon étanche le faisceau de câbles de connexion électrique et vidéo 40, tout en permettant de le courber pour faciliter sa connexion en dehors du dispositif de protection.

Ce mode de réalisation permet avantageusement de dissocier le passage pour le faisceau de câbles de connexion électrique et vidéo 40 formé par la gaine 70, et l'orifice de mise à l'air libre 56 pour le flux d'air FA. Ainsi, on peut s'assurer lors du montage du dispositif de protection 4 et du capteur optique 2 associé dans le véhicule automobile que l'orifice de mise à l'air libre 56 soit orienté vers le sol par exemple. Sur la figure 3, l'orifice de mise à l'air libre 56 et la membrane semi-perméable 66 disposée en travers de cet orifice sont illustrés tournés vers le haut mais il convient de noter qu'en pratique ils seront préférentiellement orientés vers le bas, où à tout le moins inclinés, pour limiter par exemple l'accumulation de salissure ou liquide sur la surface de la membrane, ce qui aurait pour effet de limiter le passage de l'air.

Dans ce contexte, dans une variante non représentée, on pourra prévoir d'équiper la paroi de l'embout, dans laquelle est formé l'orifice de mise à l'air libre, d'un organe de déflexion de liquide, positionné à l'extérieur du dispositif de protection et en vis-à-vis de l'orifice de mise à l'air libre. Cette variante de réalisation est particulièrement avantageuse lorsque l'orifice de mise à l'air libre 56 doit être orienté vers le haut quand le dispositif de protection 4 est monté dans un véhicule automobile 100, l'organe de déflexion permettant d'éviter que des salissures ou un liquide ne puissent boucher le passage d'air à travers la membrane. Bien entendu, l'organe de déflexion serait maintenu à une distance suffisante de l'orifice de mise à l'air libre afin de permettre à un flux d'air de circuler entre l'intérieur et l'extérieur du dispositif de protection.

Le dispositif de protection peut comporter de façon complémentaire des moyens d'absorption d'humidité 74, notamment constitués par un matériau absorbant spécifique telle que du carbonate de magnésium, et par exemple l'upsalite, ou tout autre matériau poreux équivalent. Ces moyens d'absorption d'humidité 74 peuvent être disposés sur une face interne du boîtier délimitant la cavité dans laquelle s'étend la caméra, ou bien le long de la face interne du corps tubulaire 44 de l'élément support 38.

La présence de ces moyens d'absorption d'humidité 74 peut permettre de se passer de la membrane semi-perméable, dont la fonction précédemment décrite est de d'empêcher l'humidité d'entrer dans le dispositif de protection. Cette présence peut en tout cas permettre de prévoir une membrane aux capacités hydrophobes moins performantes et donc une membrane moins chère.

L'invention, telle qu'elle vient d'être décrite, atteint bien les buts qu'elle s'était fixés et permet, par des moyens simples, de réaliser un dispositif de protection comportant des moyens pour empêcher ou limiter la condensation sur les éléments optiques associés au boîtier de protection tournant.

Il convient de noter qu'un dispositif de protection selon l'invention se distingue d'un dispositif de protection de l'art antérieur en ce que le boîtier de protection 8 ne comporte pas d'orifices au niveau de la paroi 10, et donc en ce que la partie tournante ne présente pas d'orifices en périphérie pouvant pénaliser la rotation de cette partie tournante. Ainsi, l'équilibre de la masse du boîtier de protection est préservé.

Il est à noter que les différentes variantes décrites ci-dessus d'un dispositif de protection selon l'invention peuvent être combinées ensemble afin de former de nouveau mode de réalisation non décrit.

## Revendications

1. Dispositif de protection (4) d'un capteur optique (2) de système d'assistance à la conduite (1) pour véhicule automobile (100) comportant :
- un boîtier de protection (8) formant une cavité (11) apte à recevoir au moins en partie le capteur optique (2) comprenant une surface optique (6), le boîtier de protection (8) comprenant un élément optique (12) configuré pour être disposé en regard de la surface optique (6) du capteur optique (2), le boîtier de protection (8) étant configuré pour être mobile en rotation autour d'un axe (A1),
- un moteur (14) configuré pour entraîner en rotation le boîtier de protection (8) à des vitesses permettant le nettoyage de l'élément optique (12) par effet centrifuge,
le dispositif de protection (4) étant configuré de manière à présenter une partie mobile (52) et une partie fixe (54),
**caractérisé en ce qu'**il comporte un système d'équilibrage de pression comportant un orifice de mise à l'air libre (56) permettant la communication fluidique entre l'intérieur et l'extérieur du dispositif de protection (4), l'orifice de mise à l'air libre (56) étant réalisé dans la partie fixe (54) du dispositif de protection.

2. Dispositif de protection (4) selon la revendication précédente, **caractérisé en ce que** le système d'équilibrage de pression comporte des moyens de circulation (58, 60) d'un flux d'air entre d'une part la cavité (11) formée par le boîtier de protection (8) formant partie de la partie mobile (52) du dispositif de protection et d'autre part l'orifice de mise à l'air libre (56) réalisé dans la partie fixe (54) du dispositif de protection.

3. Dispositif de protection (4) selon la revendication précédente, **caractérisé en ce que** le capteur optique (2) est porté par un élément support (38) dont au moins une embase (42) est disposée dans la cavité (11), les moyens de circulation d'un flux d'air comportant au moins un orifice de passage d'air (58) réalisé dans l'épaisseur de l'embase (42) de l'élément support (38).

4. Dispositif de protection (4) selon la revendication précédente, **caractérisé en ce que** l'élément support (38) comporte un corps tubulaire (44) prolongeant l'embase (42), ledit corps tubulaire étant creux pour former un conduit de circulation d'air formant communication fluidique entre l'orifice de passage d'air (58) et l'orifice de mise à l'air libre (56).

5. Dispositif de protection (4) selon la revendication précédente, **caractérisé en ce que** le corps tubulaire (44) est configuré pour servir de guide à un faisceau de câbles de connexion électrique et vidéo (40), le faisceau et le corps tubulaire étant dimensionnés pour laisser un passage de communication fluidique entre l'orifice de passage d'air (58) et l'orifice de mise à l'air libre (56).

6. Dispositif de protection (4) selon l'une des revendications précédentes, **caractérisé en ce qu'**un embout (62) est rendu solidaire d'un carter (16) du moteur (14), à l'opposé du boîtier de protection (8), ledit orifice de mise à l'air libre (56) étant réalisé dans une paroi périphérique de l'embout.

7. Dispositif de protection (4) selon l'une des revendications précédentes, **caractérisé en ce qu'**il comprend un organe de déflexion de liquide positionnée à l'extérieur du dispositif de protection (4) et en vis-à-vis de l'orifice de mise à l'air libre (56).

8. Dispositif de protection (4) selon l'une des revendications précédentes, **caractérisé en ce que** l'orifice de mise à l'air libre (56) est équipé d'une membrane (66) semi-perméable.

9. Dispositif de protection (4) selon l'une des revendications précédentes, **caractérisé en ce qu'**il comporte des moyens d'absorption de l'humidité (74).

10. Véhicule automobile (100) comprenant un dispositif de protection (4) d'un capteur optique (2) d'un système d'assistance à la conduite selon l'une des revendications précédentes, **caractérisé en ce que** l'orifice de mise à l'air libre (56) réalisé dans la partie fixe (54) est orienté vers le sol ou sensiblement vers le sol lorsque le véhicule automobile (100) est en situation de conduite.

## Patentansprüche

1. Schutzvorrichtung (4) eines optischen Sensors (2) eines Lenkassistenzsystems (1) für ein Kraftfahrzeug (100), die Folgendes umfasst:
- ein Schutzgehäuse (8), das einen Hohlraum (11) bildet, der dazu fähig ist, den optischen Sensor (2), der eine optische Fläche (6) beinhaltet, mindestens teilweise aufzunehmen, wobei das Schutzgehäuse (8) ein optisches Element (12) beinhaltet, das dazu konfiguriert ist, gegenüber der optischen Fläche (6) des optischen Sensors (2) angeordnet zu sein, wobei das Schutzgehäuse (8) dazu konfiguriert ist, um eine Achse (A1) drehbeweglich zu sein,
- einen Motor (14), der dazu konfiguriert ist, das Schutzgehäuse (8) mit Geschwindigkeiten in Drehung zu versetzen, die die Reinigung des optischen Elements (12) durch Zentrifugalwirkung ermöglichen,
wobei die Schutzvorrichtung (4) so konfiguriert ist, dass sie einen ersten mobilen Teil (52) und einen zweiten festen Teil (54) aufweist,
**dadurch gekennzeichnet, dass** sie ein Druckausgleichssystem umfasst, das eine Entlüftungsöffnung (56) umfasst, die die fluidische Kommunikation zwischen dem Inneren und dem Äußeren der Schutzvorrichtung (4) ermöglicht, wobei die Entlüftungsöffnung (56) in dem festen Teil (54) der Schutzvorrichtung eingebracht ist.

2. Schutzvorrichtung (4) nach dem vorhergehenden Anspruch, **dadurch gekennzeichnet, dass** das Druckausgleichssystem Mittel zur Zirkulation (58, 60) eines Luftstroms zwischen dem Hohlraum (11), der durch das Schutzgehäuse (8), welches Teil des mobilen Teils (52) der Schutzvorrichtung bildet, gebildet ist, einerseits und der Entlüftungsöffnung (56), die in dem festen Teil (54) der Schutzvorrichtung eingebracht ist, andererseits umfasst.

3. Schutzvorrichtung (4) nach dem vorhergehenden Anspruch, **dadurch gekennzeichnet, dass** der optische Sensor (2) durch ein Stützelement (38) getragen wird, von dem mindestens ein Sockel (42) in dem Hohlraum (11) angeordnet ist, wobei die Mittel zur Zirkulation eines Luftstroms mindestens eine Luftdurchgangsöffnung (58) umfassen, die in der Dicke des Sockels (42) des Stützelements (38) eingebracht ist.

4. Schutzvorrichtung (4) nach dem vorhergehenden Anspruch, **dadurch gekennzeichnet, dass** das Stützelement (38) einen rohrförmigen Körper (44) umfasst, der den Sockel (42) verlängert, wobei der rohrförmige Körper hohl ist, um eine Luftzirkulationsleitung zu bilden, die eine fluidische Kommunikation zwischen der Luftdurchgangsöffnung (58) und der Entlüftungsöffnung (56) bildet.

5. Schutzvorrichtung (4) nach dem vorhergehenden Anspruch, **dadurch gekennzeichnet, dass** der rohrförmige Körper (44) dazu konfiguriert ist, einem Bündel von Kabeln zur Elektro- und Videoverbindung (40) als Führung zu dienen, wobei das Bündel und der rohrförmige Körper so bemessen sind, dass sie zwischen der Luftdurchgangsöffnung (58) und der Entlüftungsöffnung (56) einen Durchgang zur fluidischen Kommunikation lassen.

6. Schutzvorrichtung (4) nach einem der vorhergehenden Ansprüche, **dadurch gekennzeichnet, dass** auf der entgegengesetzten Seite des Schutzgehäuses (8) ein Endstück (62) fest an einem Kasten (16) des Motors (14) befestigt ist, wobei die Entlüftungsöffnung (56) in einer umlaufenden Wand des Endstücks eingebracht ist.

7. Schutzvorrichtung (4) nach einem der vorhergehenden Ansprüche, **dadurch gekennzeichnet, dass** sie ein Flüssigkeitsumlenkorgan beinhaltet, das außerhalb der Schutzvorrichtung (4) und gegenüber der Entlüftungsöffnung (56) positioniert ist.

8. Schutzvorrichtung (4) nach einem der vorhergehenden Ansprüche, **dadurch gekennzeichnet, dass** die Entlüftungsöffnung (56) über eine halbdurchlässige Membran (66) verfügt.

9. Schutzvorrichtung (4) nach einem der vorhergehenden Ansprüche, **dadurch gekennzeichnet, dass** sie Feuchtigkeitsabsorptionsmittel (74) umfasst.

10. Kraftfahrzeug (100), das eine Schutzvorrichtung (4) eines optischen Sensors (2) eines Lenkassistenzsystems nach einem der vorhergehenden Ansprüche beinhaltet, **dadurch gekennzeichnet, dass** die Entlüftungsöffnung (56), die in dem festen Teil (54) eingebracht ist, zum Boden hin oder im Wesentlichen zum Boden hin ausgerichtet ist, wenn sich das Kraftfahrzeug (100) im Fahrzustand befindet.

## Claims

1. Device (4) for protecting an optical sensor (2) of a driver assistance system (1) for a motor vehicle (100) comprising:
- a protective casing (8) forming a cavity (11) able to at least partly accommodate the optical sensor (2) comprising an optical surface (6), the protective casing (8) comprising an optical element (12) configured to be disposed facing the optical surface (6) of the optical sensor (2), the protective casing (8) being configured to freely rotate about an axis (A1);
- a motor (14) configured to rotate the protective casing (8) at speeds allowing the optical element (12) to be cleaned by a centrifugal effect,
the protective device (4) being configured so as to have a movable part (52) and a fixed part (54),
**characterized in that** it comprises a pressure balancing system comprising an air vent orifice (56) allowing fluid communication between the inside and the outside of the protective device (4), the air vent orifice (56) being produced in the fixed part (54) of the protective device.

2. Protective device (4) according to the preceding claim, **characterized in that** the pressure balancing system comprises means (58, 60) for circulating an air flow between, on the one hand, the cavity (11) formed by the protective casing (8) forming part of the movable part (52) of the protective device and, on the other hand, the air vent orifice (56) produced in the fixed part (54) of the protective device.

3. Protective device (4) according to the preceding claim, **characterized in that** the optical sensor (2) is supported by a support element (38), at least one base (42) of which is disposed in the cavity (11), the means for circulating an air flow comprising at least one air passage orifice (58) produced in the thickness of the base (42) of the support element (38).

4. Protective device (4) according to the preceding claim, **characterized in that** the support element (38) comprises a tubular body (44) extending the base (42), said tubular body being hollow in order to form an air circulation duct forming a fluid communication between the air passage orifice (58) and the air vent orifice (56) .

5. Protective device (4) according to the preceding claim, **characterized in that** the tubular body (44) is configured to act as a guide for a bundle of electrical and video connection cables (40), the bundle and the tubular body being designed to leave a fluid communication passage between the air passage orifice (58) and the air vent orifice (56).

6. Protective device (4) according to any of the preceding claims, **characterized in that** an end fitting (62) is rigidly connected to a housing (16) of the motor (14), opposite the protective casing (8), said air vent orifice (56) being produced in a peripheral wall of the end fitting.

7. Protective device (4) according to any of the preceding claims, **characterized in that** it comprises a liquid deflection component positioned outside the protective device (4) and opposite the air vent orifice (56) .

8. Protective device (4) according to any of the preceding claims, **characterized in that** the air vent orifice (56) is equipped with a semi-permeable membrane (66) .

9. Protective device (4) according to any of the preceding claims, **characterized in that** it comprises humidity absorption means (74).

10. Motor vehicle (100) comprising a device (4) for protecting an optical sensor (2) of a driver assistance system according to any of the preceding claims, **characterized in that** the air vent orifice (56) produced in the fixed part (54) is oriented towards the ground or substantially towards the ground when the motor vehicle (100) is in a driving situation.
